# EUROPÄISCHE PATENTSCHRIFT

(11) **EP 0 638 818 B1**
(45) Veröffentlichungstag und Bekanntmachung des Hinweises auf die Patenterteilung: **26.05.1999**
(21) Anmeldenummer: 93112716.1
(22) Anmeldetag: 09.08.1993
(51) Int. Cl.: G01S 7/03

(54) **Dopplerradarmodul in Mikrostreifenleitungstechnik**
Doppler radar module using microstrip techniques
Module de radar du type doppler en technique microbande

(43) Veröffentlichungstag der Anmeldung: 15.02.1995
(73) Patentinhaber: SIEMENS AKTIENGESELLSCHAFT, 80333 München (DE)
(72) Erfinder: Lohninger, Gerhard, Dipl.-Ing., D-81549 München 90 (DE); Zimmermann, Walter, Ing. (grad.), D-84405 Dorfen 1 (DE)

(56) Entgegenhaltungen:
- EP-A- 0 129 251
- WO-A-83/03309
- DE-A- 4 013 049
- FR-A- 2 575 554
- GB-A- 2 010 036
- US-A- 4 931 799
- US-A- 4 967 201
- US-A- 5 023 624
- PATENT ABSTRACTS OF JAPAN vol. 009, no. 089 (E-309)18. April 1985 & JP-A-59 219 001 ( FUJITSU KK ) 10. Dezember 1984

## Beschreibung

Die Erfindung betrifft ein Dopplerradarmodul in Mikrostreifenleitungstechnik mit einem Gehäuse aus elektrisch leitfähigem Material.

Aus der EP-A-0 129 251 ist ein Streifenleitungsdopplerradar bekannt, bei dem ein Hochfrequenzoszillator über einen ersten Streifenleiter und einen dielektrischen Resonator mit einem zweiten Streifenleiter hochfrequenzmäßig gekoppelt ist. Der zweite Streifenleiter ist mit einer Antenne gekoppelt. Der Resonator ist zwischen den beiden Leitern derart angeordnet, dass der Antenne und Empfangsdiode eine vorgegebene Leistung zugeführt wird. Das Dopplerradar für Frequenzen von ca. 10GHz ist mit einem Gunn-Element, einer Schottky-Beam Lead-Diode und einer Keramik-Mikrowellen-Platine ausgestattet. Nachteilig ist bei dieser Anordnung allerdings die aufwendige Montage, der hohe DC-Leistungsbedarf, die hohe Lokaloszillator (LO)-Störstrahlung, die Oberwellenabstrahlung und der für eine Serienfertigung zu niedrige Integrationsgrad. Zudem muß besonders auf ESD (Electrostatic Discharge) -Schutzmaßnahmen geachtet werden.

Aus der JP 59-219 001 ist ein Mikrowellenschaltkreis bekannt, bei dem eine Mikrowellenantenne und ein Mischerelement über einen Koppler von einem Lokaloszillator gespeist wird.

Der Erfindung liegt die Aufgabe zugrunde, ein Dopplerradarmodul mit hoher Empfindlichkeit bei gleichzeitig relativ geringer Oberwellenabstrahlung so zu realisieren, dass das System eine hohe Festigkeit gegenüber elektrostatischen Aufladungen aufweist und eine kostengünstige Serienfertigung in kompakter Bauweise möglich ist.

Diese Aufgabe wird erfindungsgemäß durch ein Dopplerradar-modul in Streifenleitungstechnik mit den Merkmalen des Anspruchs 1 gelöst.

Vorteilhafte Ausgestaltungen bzw. Weiterbildungen der Erfindung sind Gegenstand zusätzlicher Ansprüche.

Bei dem erfindungsgemäßen Dopplerradarmodul speist ein mit einem dielektrischen Resonator stabilisierter Lokaloszillator (LO), beispielsweise ein FET-Oszillator über ein in Serie liegendes Mischerelement eine Mikrowellen(MW)-Antenne, vorzugsweise Patch-Antenne, welche das Oszillator- bzw. Sendesignal mit der Sendeleistung Pₛ abstrahlt. Das von einem bewegten Objekt zurückreflektierte und empfangene Signal mit der Leistung Pₑ wird über dieselbe Antenne dem Mischer zugeführt und mit dem dem Mischvorgang dienenden Anteil des Oszillator(LO)-Signals zum Dopplersignal gemischt.

Durch die serielle Anordnung von Lokaloszillator, Mischerelement und Antenne wird ein hoher Mischwirkungsgrad und eine hohe Empfindlichkeit bei gleichzeitig minimiert abgestrahlter Sendeleistung erreicht.

Durch den Aufbau des Dopplerradars mit einer Multilayerplatine, bei der ein Lokaloszillator auf der einen Seite und ein Mischer mit der Antennenspeisung auf der anderen Seite angeordnet sind, wird das Gehäuse des Dopplerradars in zwei Kammern geteilt. Diese vorteilhafte Maßnahme ermöglicht eine kompakte Bauweise und eine Minimierung der Oberwellenabstrahlung.

Die hohe ESD-Festigkeit wird antennenseitig durch eine zur Masse führende λ/4-Leitung und ausgangsseitig durch einen Schutzwiderstand zum Mischer erreicht.

Anhand eines in den Figuren der Zeichnung dargestellten Ausführungsbeispiels wird die Erfindung im folgenden näher erläutert. Es zeigen
- FIG 1: eine Prinzipschaltung des Dopplerradars,
- FIG 2: das Mischerprinzip,
- FIG 3: eine Ausführung des Mischers,
- FIG 4: eine Draufsicht auf die eine Seite der Multilayer-platine mit dem dortigen Schaltungsteil,
- FIG 5: eine Draufsicht auf die andere Seite der Multilayer-platine mit dem dortigen Schaltungsteil des Dopplerradars,
- FIG 6: eine Draufsicht auf das Dopplerradarmodul ohne Deckel und
- FIG 7: einen Querschnitt des Moduls nach FIG 6.

Das in FIG dargestellte, als Bewegungssensor verwendete Dopplerradar besteht im wesentlichen aus den drei Funktionseinheiten: dem eigentlichen Dopplerradarmodul, einem NF-Vorverstärker VA und einer Spannungsstabilisierung VS. Ein mit einem dielektrischen Resonator stabilisierter Lokaloszillator 2, in diesem Beispiel ein FET-Oszillator, speist über einen in Serie liegenden Mischer mit den Mischerdioden 3 und 4 eine Mikrowellen-Antenne 5, vorzugsweise Patch-Antenne, über die ein Sendesignal abgestrahlt wird. Antennenseitig ist eine zur Masse führende λ/4-Streifenleitung 7 und ausgangsseitig ein Schutzwiderstand 8 und ein Diodenverspannungswiderstand 10 zum Mischer 3, 4 vorgesehen. Die über die Antenne abgestrahlte Mikrowellenleistung wird bei Bewegungsvorgängen im Empfindlichkeitsbereich des Sensors reflektiert und den Mischerdioden 3, 4 zugeführt und damit ein Dopplersignal erzeugt. Ein nachfolgender rauscharmer NF-Vorverstärker VA verarbeitet das Dopplersignal und bildet mit der Spannungsstabilisierung VS die weiteren zwei Komponenten der Funkanlage, die beispielsweise auf einer einseitig bestückten Leiterplatte integriert sind.

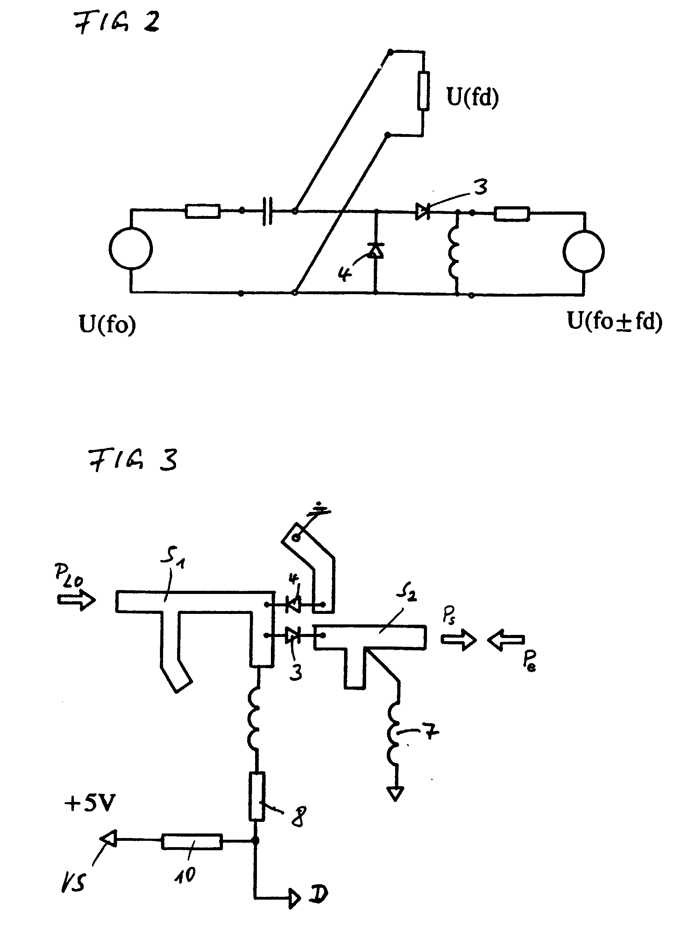

In FIG 2 ist das Mischerprinzip des Dopplerradars mit in Serie liegenden Mischern, beispielsweise Schottky-Dioden 3, 4 gezeigt. Mit U(fo) ist das LO-Signal bei der Frequenz fo, mit U(fo ± fd) das empfangene Signal bei den möglichen Frequenzen fo ± fd und mit U(fd) das erzeugte Dopplersignal bei der Dopplerfrequenz fd bezeichnet. Bewegt sich ein im Empfindlichkeitsbereich des Sensors befindliches Objekt, das die MW-Strahlung reflektiert, so wird die frequenzverschobene reflektierte Welle von der MW-Antenne aufgenommen und wiederum dem Mischer zugeführt. Der Mischprozeß aus dem LO-Signal und der frequenzversetzten Welle liefert das geschwindigkeitsproportionale Dopplersignal.

Der in FIG 3 dargestellte Mischer besteht in diesem Beispiel aus zwei Low Barrier Silizium Dioden 3, 4. Die im Serienzweig zur Antenne liegende Diode 3 dient dem Mischvorgang; die Diode 4 mit der Schaltung einer Mikrostreifenleitung zur Masse dient der Rauschunterdrückung. Das LO-seitige Anpaßnetzwerk S₁ bietet der Diode 3 einen niederohmigen Abschluß und erfüllt zwei Funktionen. Durch die Fehlanpassung zum Lokaloszillator 2 wird einerseits die abgegebene Leistung Pₛ soweit reduziert, daß die Sendeleistung an der Antenne 5 auf einen geringen Wert von z.B. OdBm EIRP abgesenkt wird, die Mischfunktion aber voll erhalten bleibt. Andererseits wird damit ein optimaler LO-seitiger Mischerabschluß für das Empfangssignal Pₑ erreicht. Das Netzwerk S₂ dient der Empfangsanpassung.

Als platzsparende Antenne 5 wird vorzugsweise eine Patch-Antenne aus Teflonmaterial verwendet. Die Anbindung der Mischerstruktur 3, 4 und der Antennenanpassung auf der Multilayerplatine 6 realisiert man mit einem Anschlußdrähtchen aus Silberdraht. Ein HF-Durchführungsbauelement kann damit entfallen. Außerdem ist die verwendete Mikrowellen-Antenne 5 durch eine am Ende mit einem Kurzschluß versehene λ/4-Streifenleitung 7 auf der Multilayerplatine 6 mit dem Gehäuse verbunden. Dadurch ist eine ESD-Gefährdung durch Berühren der Patch-Antenne vermieden. Der nach außen geführte Abgriff für das Dopplersignal D ist durch einen Schutzwiderstand 8, in diesem Fall einen 160 Ohm-Widerstand von der Mischerstruktur 3, 4 geschützt. An dem nach außen geführten Abgriff zum Spannungsregler VS liegt ein 51 kOhm-Widerstand als Diodenvorspannungswiderstand 10.

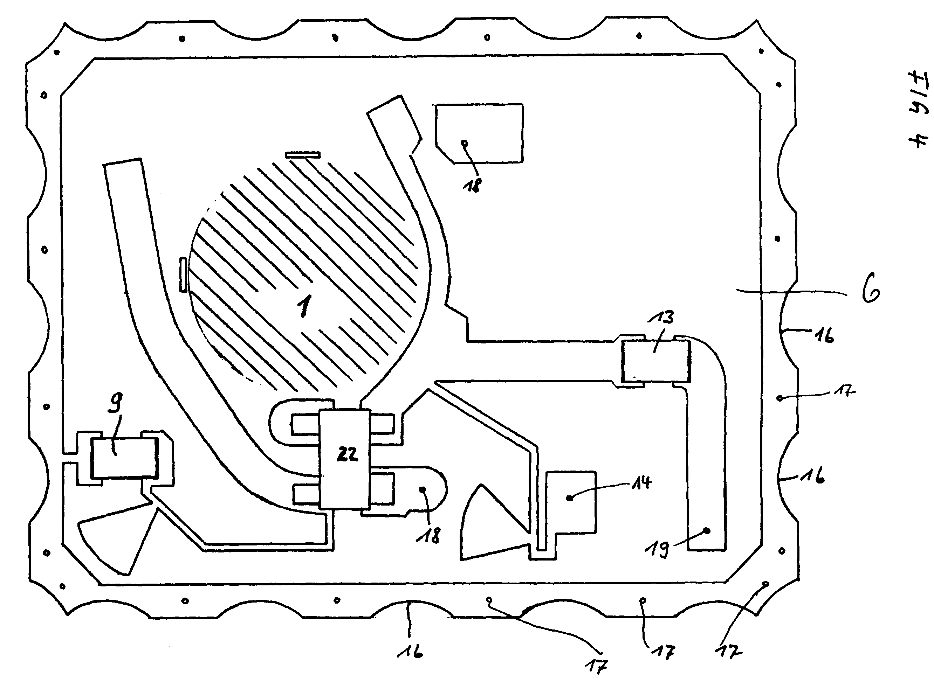

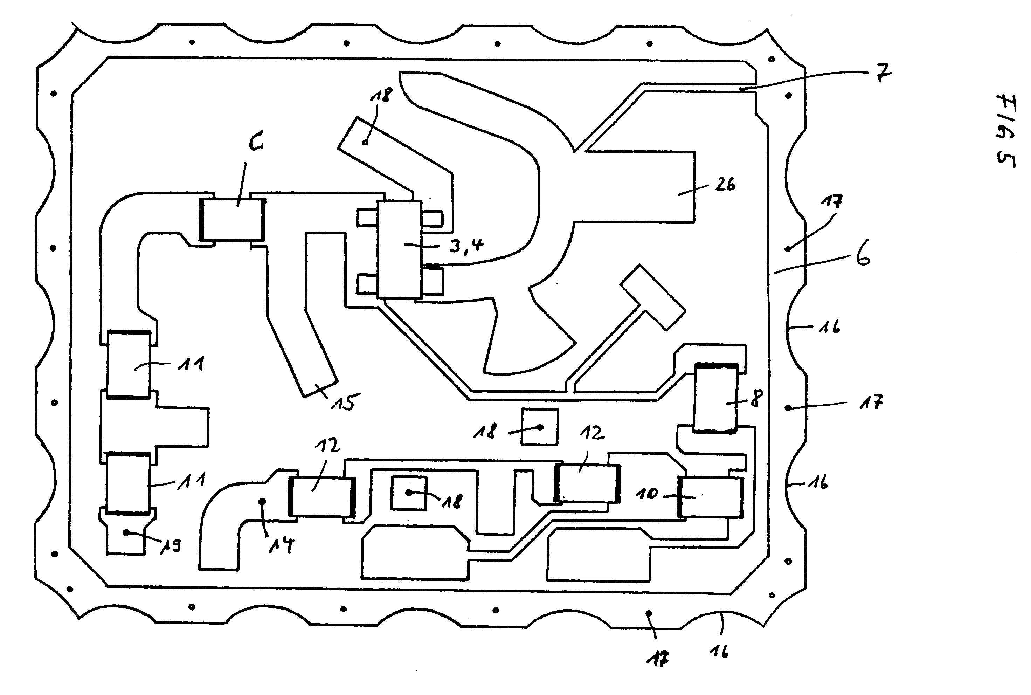

Die Figuren 4 und 5 zeigen Draufsichten auf die beiden Seiten der Multilayerplatine 6 mit den jeweiligen Schaltungsteilen. Die Mikrowellen-Multilayerplatine 6 besteht vorzugsweise aus zwei beidseitig Cu-kaschierten, vorher definiert freigeätzten Teflonplatinen, die miteinander verklebt sind. Es ist vorteilhaft, daß für diese Klebung nur ein bedingt HF-tauglicher Kleber verwendet werden kann, da hier die Dielektrizitätskonstante des Klebers keine entscheidende Rolle spielt. Weiterhin ist auch von Vorteil, daß eine beidseitige Mikrowellen-Führung möglich ist.

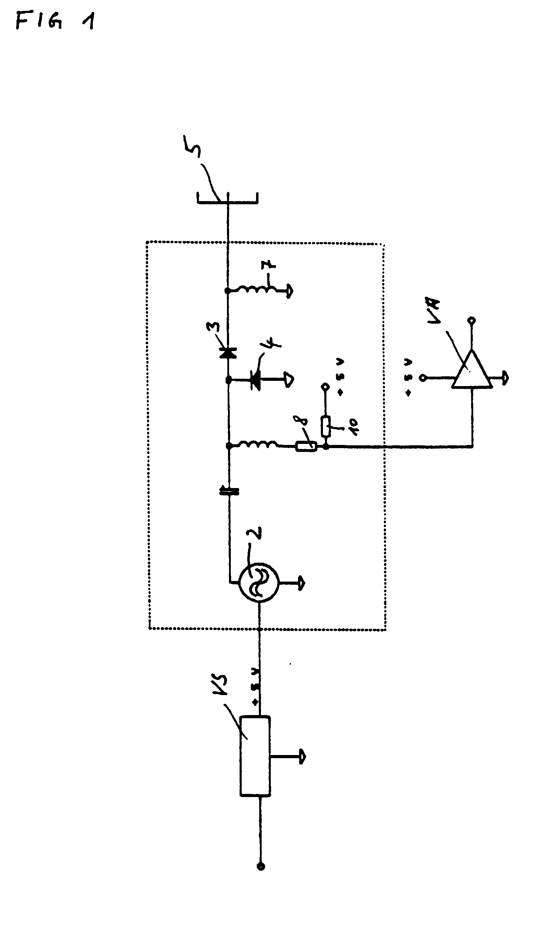

Die Multilayerplatine 6 zeichnet sich dadurch aus, daß sich auf der einen Seite der Platine gemäß FIG 4 die Streifenleitungen des Mikrowellenoszillators 2 (FIG 1), der dielektrische Resonator 1, in diesem Beispiel ein Feldeffekttransistor 22 als aktives Element des Lokaloszillators 2 (FIG 1), der Gate-DC-Widerstand 9 und der HF-Serienwiderstand 13 befinden. Der optimal dimensionierte Serienwiderstand 13 gewährleistet die Anpassung des Oszillators 2 an die Lastimpedanz und reduziert gleichzeitig die Ausgangsleistung des Oszillators.

Auf der anderen Seite der Multilayerplatine 6 befinden sich gemäß FIG 5 eine Oberwellenfilterstruktur in Form von Widerständen 11, Transistorwiderstände 12, der Diodenmischer 3, 4 und die Antennenanpassung 26. Mit C ist ein Entkopplungskondensator zwischen Oszillator 2 und Mischer 3, 4 bezeichnet. Die Mikrowelle wird durch das aus zwei Widerständen 11 bestehende Oberwellenfilter und einen Mikrowellenstub 15 dem Mischer 3, 4 zugeführt.

Das vom Oszillator 2 (FIG 1) erzeugte LO-Signal wird durch eine Durchkontaktierung 19 von der einen Seite zur anderen Seite der Platine geführt. Die beiden Cu-Mittellagen müssen daher eine entsprechende Freiätzung aufweisen. Die Spannungszuführung zum Transistor 22 über die Widerstände 12 von einer Seite zur anderen basiert auf dem gleichen Prinzip (Durchkontaktierung 14). Die Durchkontaktierungen 16, 17 (Außendurchmesser 3,4 mm bzw. Innendurchmesser 0,5mm) am Umfang der Multilayerplatine 6 dienen zur Bildung einer HF-Masse der beiden Cu-Mittellagen und zur Vermeidung von HF-Abstrahlung an den Rändern der Multilayer-platine 6. Die Durchkontaktierungen 18 verbinden den FET 22 bzw. die Paralleldiode 4 des Mischers mit den beiden Cu-Mittellagen. Durch das Einlöten der Multilayerplatine 6 in das Gehäuse wird somit die Verbindung der beiden Cu-Mittellagen (Zwischenschichten) mit dem Gehäuse gewährleistet.

Von besonderem Vorteil ist, daß durch die Lage und Anordnung der Durchkontaktierungen 16 am Rand einer jeden Einzelplatine 6 die Herstellung einer Vielzahl von Platinen in einem Nutzen wesentlich erleichtert wird. Die Positionierung der Durchkontaktierungen 16 und ein Ausstanzvorgang erzeugen dabei eine Perforation bzw. eine Zahnung, die der einer Briefmarke ähnlich ist.

Die Multilayerplatine 6 wird beidseitig mit oberflächenmontierbaren Bauelementen bestückt und kann somit in der Großserie mit Bestückungsautomaten hergestellt werden.

Das Streifenleitungsdopplerradar umfaßt im wesentlichen folgende Komponenten:
- Eine Multilayerplatine mit Oszillator und Mischer.
- Eine Mikrowellenantenne.
- Ein Gehäuse aus elektrisch leitfähigem Material mit Deckel und Abstimmschraube.
- Eine NF-Platine mit Spannungsregler und Dopplersignalverstärker.

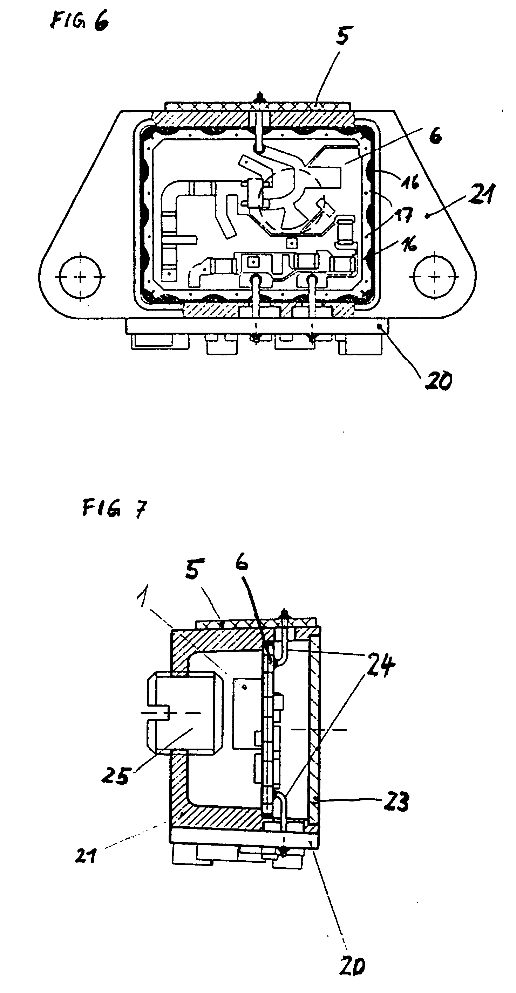

Die FIG 6 und 7 zeigen das Dopplerradarmodul mit der NF-Platine 20. Die NF-Platine 20 umfaßt eine stabilisierte +5V Spannung und eine Aufbereitung des Dopplersignals. Der Dopplersignalvorverstärker VA (FIG 1) leistet eine Spannungsverstärkung von 1000.

Nachdem die Mikrowellenantenne 5 und die NF-Platine 20 auf das Gehäuse 21 gelötet wurden, lötet man wiederum die Multilayerplatine 6 auf einen dafür vorgesehenen Gehäuseabsatz ein.

Anschließend werden zur Verbindung der Multilayerplatine 6 mit der Mikrowellenantenne 5, der DC-Versorgung und der Dopplersignalzuleitung drei Silberdrahtstücke 24 eingesetzt und der Gehäusedeckel 23 (FIG 7) eingelötet. Das Verlöten aller Komponenten gewährleistet einen hohen Qualitätsstandard. Abschließend wird mit Hilfe einer Abstimmschraube 25 die Frequenz der abgestrahlten Leistung eingestellt.

Das erfindungsgemäße Streifenleitungsdopplerradar läßt sich z.B. als Bewegungsmelder, Türöffner und ähnlichen Anwendungen in vielen Bereichen verwenden.

## Patentansprüche

1. Dopplerradar-Modul in Mikrostreifenleitungstechnik mit einem Gehäuse aus elektrisch leitfähigem Material, einem mit einem dielektrischen Resonator (1) stabilisierten Lokaloszillator (2), einem Mischerelement (3, 4) und einer Mikrowellen-Antenne (5), **dadurch gekennzeichnet**,
dass der Lokaloszillator (2), das Mischerelement (3, 4) und die Mikrowellen-Antenne (5) seriell zueinander angeordnet sind, derart, dass im Betrieb des Dopplerradar-Moduls die Mikrowellen-Antenne (5) über das Mischerelement (3, 4) von dem Lokaloszillator (2) gespeist wird.

2. Dopplerradar-Modul nach Anspruch 1, **dadurch gekennzeichnet**,
dass das Mischerelement zwei Mischerdioden (3, 4) aufweist, von denen eine (3) in einem Serienzweig zur Antenne liegt und dem Mischvorgang dient und die andere (4) über eine Mikrostreifenleitung zur Masse geschaltet ist und der Rauschunterdrückung dient und dass das Mischerelement (3, 4) eine Fehlanpassungsschaltung (F₁) zum Lokaloszillator (2) sowie eine Antennenanpassschaltung (26) zur Mikrowellen-Antenne (5) aufweist.

3. Dopplerradar-Modul nach Anspruch 1 oder 2, **dadurch gekennzeichnet**,
dass eine Multilayerplatine (6) vorgesehene ist, die das Gehäuse (21) in zwei Kammern teilt und dass der Lokaloszillator (2) mit dem Transistor (22) auf der einen Seite und der Mischer (3,4) mit der Antennenspeisung auf der anderen Seite der Multilayerplatine (6) angeordnet sind.

4. Dopplerradar-Modul nach Anspruch 3, **dadurch gekennzeichnet**,
dass die Multilayerplatine (6) eine durchgehende leitende Mittelschicht und eine beidseitige Mikrowellenführung aufweist.

5. Dopplerradar-Modul nach Anspruch 4, **dadurch gekennzeichnet**,
dass die Multilayerplatine (6) aus zwei beidseitig Cukaschierten, vorher definiert freigeätzten Platinen besteht, deren Rückseiten verbunden sind.

6. Dopplerradar-Modul nach Anspruch 5, **dadurch gekennzeichnet**,
dass die Rückseiten der beiden Platinen mit einem Kleber verbunden sind.

7. Dopplerradar-Modul nach einem der Ansprüche 1 bis 6, **dadurch gekennzeichnet**,
dass antennenseitig eine zur Masse führende λ/4-Streifenleitung (7) und ausgangsseitig ein Schutzwiderstand (8) zum Mischerelement (3, 4) vorgesehen sind.

8. Dopplerradar-Modul nach einem der Ansprüche 1 bis 7, **dadurch gekennzeichnet**,
dass das aktive Element des Lokaloszillators (2) ein Feldeffekt-Transistor (22) oder ein bipolarer Hochfrequenz-Transistor ist.

9. Dopplerradar-Modul nach einem der Ansprüche 3 bis 7, **dadurch gekennzeichnet**,
dass auf der einen Seite der Multilayerplatine (6) die Streifenleitungen des Lokaloszillators (2), der dielektrische Resonator (1), ein Feldeffekt-Transistor (22) als aktives Element des Lokaloszillators (2), ein Gate-DC-Widerstand (9) und ein HF-Serienwiderstand (13) angeordnet sind, dass auf der anderen Seite der Multilayer-Platine (6) eine Oberwellenfilterstruktur (11), Spannungszuführungs-Vorwiderstände (12), das Mischerelement (3,4) und die Antennenanpassungs-Schaltung (26) angeordnet sind und dass die Multilayerplatine (6) eine Durchkontaktierung (19) von der einen Seite zur anderen Seite aufweist, durch die das vom Lokaloszillator (2) erzeugte Oszillator-Signal durch die Multilayerplatine (6) zuführbar ist.

10. Dopplerradar-Modul nach einem der Ansprüche 5 bis 7, **dadurch gekennzeichnet**,
dass der Umfang der Multilayerplatine (6) zum Verbinden der beiden Cu-Mittellagen mit dem Gehäuse (21), der Abdichtung der beiden Kammern und zur Vermeidung von HF-Abstrahlung an den Rändern mit einer Vielzahl von Durchkontaktierungen (16,17) versehen ist.

## Claims

1. Doppler radar module using microstrip technology and having a housing composed of electrically conductive material, a local oscillator (2) which is stabilized by a dielectric resonator (1), a mixer element (3, 4) and a microwave antenna (5), characterized in that the local oscillator (2), the mixer element (3, 4) and the microwave antenna (5) are arranged in series with one another in such a manner that, during operation of the Doppler radar module, the microwave antenna (5) is fed from the local oscillator (2) via the mixer element (3, 4).

2. Doppler radar module according to Claim 1, characterized in that the mixer element has two mixer diodes (3, 4), one (3) of which is in a series path to the antenna and is used for the mixing process, and the other (4) is connected via a microstrip to earth and is used for noise suppression, and in that the mixer element (3, 4) has a mismatching circuit (F₁) for the local oscillator (2) and an antenna matching circuit (26) for the microwave antenna (5).

3. Doppler radar module according to Claim 1 or 2, characterized in that a multilayer board (6) is provided, which splits the housing (21) into two chambers, and in that the local oscillator (2) with the transistor (22) is arranged on one side of the multilayer board (6), and the mixer (3, 4) with the antenna feed is arranged on the other side of the multilayer board (6).

4. Doppler radar module according to Claim 3, characterized in that the multilayer board (6) has a continuous conductive middle layer, and a microwave guide on both sides.

5. Doppler radar module according to Claim 4, characterized in that the multilayer board (6) comprises two boards which are coated with copper on both sides, are etched free in a manner defined in advance, and whose rear sides are connected.

6. Doppler radar module according to Claim 5, characterized in that the rear sides of the two boards are connected using an adhesive.

7. Doppler radar module according to one of Claims 1 to 6, characterized in that a λ/4 stripline (7) which is connected to earth is provided on the antenna side, and a protective resistor (8) for the mixer element (3, 4) is provided on the output side.

8. Doppler radar module according to one of Claims 1 to 7, characterized in that the active element of the local oscillator (2) is a field-effect transistor (22) or a bipolar radio-frequency transistor.

9. Doppler radar module according to one of Claims 3 to 7, characterized in that the striplines of the local oscillator (2), the dielectric resonator (1), a field-effect transistor (22) as an active element of the local oscillator (2), a gate DC resistor (9) and an RF series impedance (13) are arranged on one side of the multilayer board (6), in that a surface acoustic wave filter structure (11), voltage supply series resistors (12), the mixer element (3, 4) and the antenna matching circuit (26) are arranged on the other side of the multilayer board (6), and in that the multilayer board (6) has a through-plated region (19) from one side to the other side, through which the oscillator signal produced by the local oscillator (2) can be supplied through the multilayer board (6).

10. Doppler radar module according to one of Claims 5 to 7, characterized in that the circumference of the multilayer board (6) is provided with a multiplicity of through-plated regions (16, 17) in order to connect the two copper middle layers to the housing (21), to seal the two chambers and to avoid RF emission at the edges.

## Revendications

1. Module de radar Doppler en technique microbande, comportant un boîtier en matériau conducteur d'électricité, un oscillateur (2) local stabilisé par un résonateur (1) diélectrique, un élément (3, 4) mélangeur et une antenne (5) hyperfréquence, caractérisé en ce que l'oscillateur (2) local, l'élément (3, 4) mélangeur et l'antenne (5) hyperfréquence sont montés en série les uns par rapport aux autres de telle manière que, pendant le fonctionnement du module de radar Doppler, l'antenne (5) hyperfréquence est alimentée par l'oscillateur (2) local par l'intermédiaire de l'élément (3, 4) mélangeur.

2. Module de radar Doppler suivant la revendication 1, caractérisé en ce que l'élément mélangeur comporte deux diodes (3, 4) de mélangeur, dont l'une (3) se trouve dans une branche en série avec l'antenne et sert à l'opération de mélangeage et dont l'autre (4) est reliée à la masse par l'intermédiaire d'une microbande et sert à la suppression du bruit et en ce que l'élément (3, 4) mélangeur comporte un circuit (F₁) de déséquilibre pour l'oscillateur (2) local, ainsi qu'un circuit (26) d'adaptation d'antenne pour l'antenne (5) hyperfréquence.

3. Module de radar Doppler suivant la revendication 1 ou 2, caractérisé en ce qu'il est prévu une platine (6) multicouche qui subdivise le boîtier (21) en deux chambres et ce que l'oscillateur (2) local comportant le transistor (22) est monté d'un côté de la platine (6) multicouche et le mélangeur (3, 4) comportant le dispositif d'alimentation d'antenne de l'autre côté de la platine (6) multicouche.

4. Module de radar Doppler suivant la revendication 3, caractérisé en ce que la platine (6) multicouche a une couche médiane conductrice continue et un guidage de micro-ondes de part et d'autre.

5. Module de radar Doppler suivant la revendication 4, caractérisé en ce que la platine (6) multicouche est constituée de deux platines plaquées de cuivre de part et d'autre, qui ont été dégagées précédemment par attaque chimique de manière définie et dont les côtés arrières sont reliés.

6. Module de radar Doppler suivant la revendication 5, caractérisé en ce que les côtés arrières des deux platines sont reliés par une colle.

7. Module de radar Doppler suivant l'une des revendications 1 à 6, caractérisé en ce qu'il est prévu côté antenne une microbande (7) quart d'onde allant à la masse et, côté sortie, une résistance (8) protectrice de l'élément (3, 4) mélangeur.

8. Module de radar Doppler suivant l'une des revendications 1 à 7, caractérisé en ce que l'élément actif de l'oscillateur (2) local est un transistor (22) à effet de champ ou un transistor bipolaire haute fréquence.

9. Module de radar Doppler suivant l'une des revendications 3 à 7, caractérisé en ce qu'il est monté d'un côté de la platine (6) multicouche les microbandes de l'oscillateur (2) local, le résonateur (1) diélectrique, un transistor (22) à effet de champ servant d'élément actif de l'oscillateur (2) local, une résistance (9) d'effet de grille et une résistance (13) série haute fréquence, en ce qu'il est monté de l'autre côté de la platine (6) multicouche une structure (11) de filtre d'harmonique, une résistance (12) série d'envoi de tension, l'élément (3, 4) mélangeur et le circuit (26) d'adaptation de l'antenne et en ce que la platine multicouche comporte un trou (19) métallisé d'un côté à l'autre, par lequel le signal d'oscillateur produit par l'oscillateur (2) local peut être envoyé à travers la platine (6) multicouche.

10. Module de radar Doppler suivant l'une des revendications 5 à 7, caractérisé en ce que le pourtour de la platine (6) multicouche est muni d'une pluralité de trous (16, 17) métallisés pour relier les deux couches médianes en cuivre au boîtier (21), pour rendre étanches les deux chambres et pour empêcher un rayonnement haute fréquence sur les bords.
